# EUROPÄISCHE PATENTANMELDUNG

(11) **EP 1 661 785 A1**
(43) Veröffentlichungstag der Anmeldung: **31.05.2006**
(21) Anmeldenummer: 05023577.9
(22) Anmeldetag: 28.10.2005
(51) Int. Cl.: B61L 15/00, G01R 31/00

(54) **Vorrichtung zur Prüfung von Steckverbindungskabeln an Triebfahrzeugen, vorzugsweise an schienengebundenen Triebfahrzeugen**

(30) Priorität: 24.11.2004 DE 202004018242 U
(71) Anmelder: DB Regio AG, 60326 Frankfurt (DE); Railion Deutschland AG, 55116 Mainz (DE)
(72) Erfinder: Draheim, Bernhard, 80939 München (DE); Krajnij, Sergej, 81248 München (DE)
(74) Vertreter: Zinken-Sommer, Rainer

(57) **Zusammenfassung**

Die Erfindung betrifft eine Vorrichtung zur Prüfung von Steckverbindungen und/oder Verbindungskabeln an Triebfahrzeugen, vorzugsweise an schienengebundenen Triebfahrzeugen, wobei alle Kommunikationsfunktionen zwischen einem Triebfahrzeug und dem mit ihr verbundenen Wagenpark und/oder einem anderen Triebfahrzeug schaltungstechnisch überprüft werden.

Der Erfindung liegt die Aufgabe zugrunde, den Nachteil des Standes der Technik zu beseitigen, in dem ein Prüfgerät entwickelt wird, welches in der Lage ist durch eine Person bedient zu werden und mit dem in kürzester Zeit alle wichtigen Kommunikationssysteme eines Triebfahrzeuges sicher und schnell auf ihre volle Funktionsfähigkeit überprüft werden kann.

Dies wird erfindungsgemäß dadurch erreicht, dass
ein mobiles, tragbares, elektronisches Prüfgerät - welches über eine Steckvorrichtung für die auf schienengebundenen Triebfahrzeugen vorhandene UIC-Dose und/oder ein UIC-Verbindungskabel verfügt -
Tast- und/oder Berührungselemente zur Auslösung eines Signals für eine Funktionsprüfung aller über die UIC-Dose zu versendender Signale, wie beispielsweise
- der Notbremsüberwachung und/oder
- des Zugbahnfunkes und/oder
- der GSMR-Anlage und/oder
- des Lok-zu-Lok-Funkes und/oder
- der Türöffnung oder -schließung und/oder Steuerspannungspolaritätsrichtigkeit
mit dazugehörigen optischen und/oder akustischen Signaleinrichtungen sowie ein Mikrophon (14) aufweist.

## Beschreibung

Die Erfindung betrifft eine Vorrichtung zur Prüfung von Steckverbindungen und/oder Verbindungskabeln an Triebfahrzeugen, vorzugsweise an schienengebundenen Triebfahrzeugen, wobei alle Kommunikationsfunktionen zwischen einem Triebfahrzeug und dem mit ihr verbundenen Wagenpark und/oder einem anderen Triebfahrzeug schaltungstechnisch überprüft werden.

Immer wieder liegen der Instandsetzung/Instandhaltung von Triebfahrzeugen Störungen vor, die im Zusammenhang mit den UIC-Dosen und damit mit den Kommunikationsfunktionen bzw. mit anderen verschiedenen wichtigen Funktionen zwischen der Lok und dem Wagenpark stehen.

Die Überprüfung bzw. die Suche nach den Funktionsstörungen gestaltet sich im Allgemeinen bisher aus verschiedenen Gründen sehr schwierig. Zum Einen ist eine Störungssuche ohne Wagenpark oftmals unmöglich, zum Anderen kann die Störung nicht nur in der UIC-Dose sondern auch im Verbindungskabel zwischen Lok und Wagenpark liegen.

Zum Dritten ist die Fehlersuche derzeit sehr zeitaufwendig und personenintensiv, da noch keine Ein-Mann-Bedienung möglich ist. Für eine Suche sind derzeit mindestens 2 Personen mit mehreren unabhängigen, relativ unhandligen Prüfgeräten notwendig.

Gleichzeitig wurden immer wieder Störungen im Zugbahnfunk gemeldet. Da eine tadellose Funktion dieser Verbindung für einen sicheren Fahrbetrieb unerlässlich ist, muss auch diese Störung schnell und unkompliziert zu beheben sein. Auch der reibungslose Gebrauch der Schwanenhalsmikrophone, der Verbindungskabel; der GSMR-Anlagen; der Türöffnungs- und -schließanlage, des Zugbahnfunkes und der Notbremsüberwachung ist eine Voraussetzung für die Sicherheit des Dienstpersonals wie auch der Fahrgäste.

Bekannt ist ein Verfahren zur Überwachung von Daten betreffend den Betrieb von Schienenfahrzeugen, wobei die betreffenden Daten von Einrichtungen zur Datenerfassung erfasst, die erfassten Daten gewichtet und die gewichteten Daten zu einem repräsentativen Gesamtgewicht verknüpft werden (DE 199 11 848 A1).

Das Verfahren dient der Erfassung und Überwachung von Fahrzeugdaten während des Betriebes, wie Sensoren an Radreifen oder zur Messung der Lagertemperatur an Achsen von Drehgestellen und ist für eine Überwachung von Fahrzeugsignalen zwischen Triebfahrzeugen und Wagenpark im Rahmen der Fahrzeuginstandhaltung und/oder - setzung nicht geeignet.

Aus dem Stand der Technik sind keine Prüfgeräte bekannt, die durch eine Person auf dem Triebfahrzeug eine sichere und schnelle Funktionsprüfung aller wichtigen Kommunikationssysteme zulässt.

Der Erfindung liegt die Aufgabe zugrunde, den Nachteil des Standes der Technik zu beseitigen, in dem ein Prüfgerät entwickelt wird, welches in der Lage ist durch eine Person bedient zu werden und mit dem in kürzester Zeit alle wichtigen Kommunikationssysteme eines Triebfahrzeuges sicher und schnell auf ihre volle Funktionsfähigkeit überprüft werden kann.

Dies wird erfindungsgemäß dadurch erreicht, dass
ein mobiles, tragbares, elektronisches Prüfgerät - welches über eine Steckvorrichtung für die auf schienengebundenen Triebfahrzeugen vorhandene UIC-Dose und/oder ein UIC-Verbindungskabel verfügt - Tast- und/oder Berührungselemente zur Auslösung eines Signals für eine Funktionsprüfung aller über die UIC-Dose zu versendender Signale, wie beispielsweise
- der Notbremsüberwachung und/oder
- des Zugbahnfunkes und/oder
- der GSMR-Anlage und/oder
- des Lok-zu-Lok-Funkes und/oder
- der Zugbussysteme und/oder
- der Türöffnung oder -schließung und/oder Steuerspannungspolaritätsrichtigkeit
mit dazugehörigen optischen und/oder akustischen Signaleinrichtungen sowie ein Mikrophon aufweist.

Die optischen Signaleinrichtungen sind Leuchtdioden oder ähnliche Leuchtmittel und sollen bei einer positiven Funktionsprobe des jeweiligen Ausgangssignals durch ein Aufleuchten diesen Zustand dem Prüfenden signalisieren.

Als akustische Signaleinrichtung im Prüfgerät ist ein Lautsprecher oder eine ähnliche, ein akustisches Signal ausstrahlende Einrichtung eingebunden. Dieser Lautsprecher gibt bei einer Prüfung des Lok-zu-Lok-Funk die in das Mikrophon gesprochenen Meldungen akustisch wieder.

Das Prüfgerät weist einen elektronischen Schaltkreis auf, der die über die UIC-Dose zu versendenden Signale auf ihre Vollständigkeit und Plausibilität prüft.

Zur Notbremsüberwachung des angehangenen Wagenparkes ist die entsprechende Phase der UIC-Dose über einen Resonanzschwingkreis und einen Trafo mit dem 1000 Hz Anzeige-Modul und der Endstufe IC2 schaltungstechnisch verbunden.

Zur Zugbahnfunküberwachung (ZBF=GSMR) von Lok/Lok wird eine Funktionsfähigkeitskontrolle in der Art durchgeführt, dass die entsprechende Phase der UIC-Dose über ein oder mehrere Relais und sowie die Endstufe IC2 mit Mikrophonverstärker IC1 und ein oder mehreren LED-Anzeigen verbunden ist.

Zur Zugbahnfunküberwachung (ZBF=GSMR) von Lok/Wagen wird eine Funktionsfähigkeitskontrolle in der Art durchgeführt, dass die entsprechende Phase der UIC-Dose über ein oder mehrere Relais und die Endstufe IC2 mit ein oder mehreren LED-Anzeigen verbunden ist.

Zur Überprüfung der Türöffnungs- und/oder - Schließungsfunktion und/oder der Steuerspannungspolaritätsrichtigkeit wird eine Funktionsfähigkeitskontrolle in der Art durchgeführt, dass die entsprechende Phase der UIC-Dose über eine LED-Anzeige und einen Taster mit den Batterien verbunden ist.

### Vorteile der Erfindung:

a) Das Prüfgerät kann gemeldete Störungen auf der Lok sofort und zweifelsfrei erkennen.
b) Es erlaubt mittels eines Verbindungskabels zwischen der UIC-Dose und dem Prüfgerät eine Mitnahme des Geräts auf den Führerstand, was einen Ein-Mann-Betrieb möglich macht.
c) Es kann Störungen im Verbindungskabel zwischen der Lok und dem Wagenpark herausfiltern ohne den Wagenpark vor Ort zu haben.
d) Es ist für alle Loktypen einsetzbar.
e) Es ist jederzeit durch weitere Suchfunktionen erweiterbar, falls notwendig.
f) Es kann bei Bedarf auch an ganz speziellen Eigenschaften einer Lok angepasst werden.
g) Es kann kostengünstig hergestellt werden
h) Es ist relativ klein und gut handhabbar.

### Ausführungsbeispiel

Anhand eines Ausführungsbeispieles soll nachfolgend die Erfindung näher erläutert werden. Dabei zeigt:

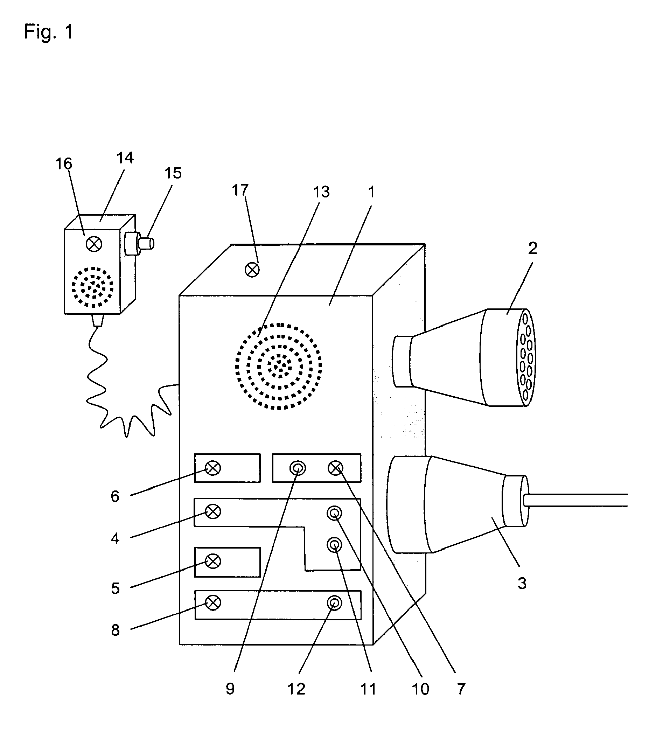

- Figur 1 - das Prüfgerät in der Ansicht

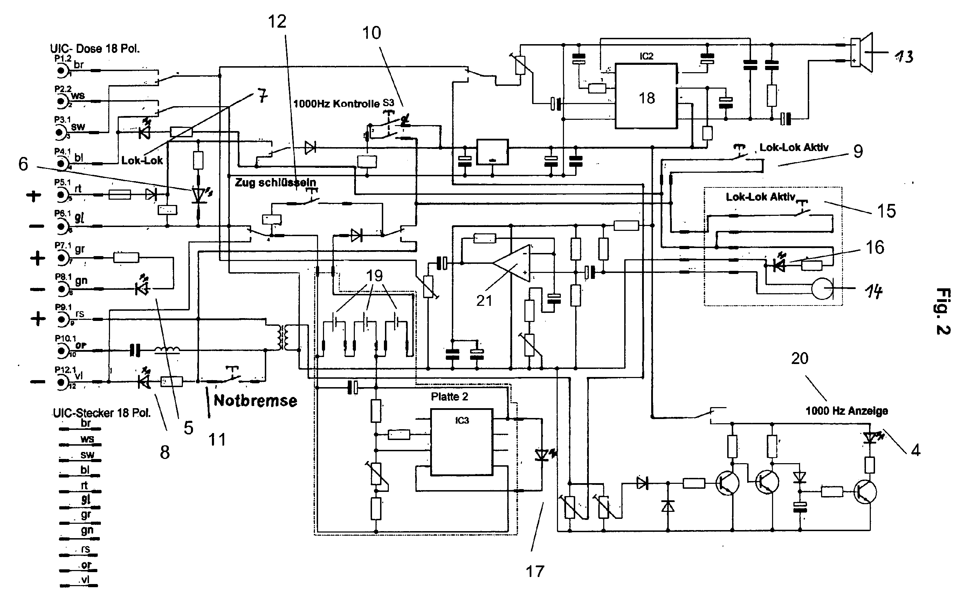

- Figur 2 - den elektronischen Schaltplan

Das Prüfgerät 1 weist auf seiner Rückseite eine Steckvorrichtung 2 für ein direktes Einführen in die nicht dargestellte UIC-Dose des Triebfahrzeuges sowie eine Einführung für ein UIC-Kabel 3 auf.
Auf seiner Vorderseite befinden sich jeweils Leuchtdioden für eine der Notbremsüberwachung 4, den Zugbahnfunk (ZBF=GSMR) Lok/Lok 7 und 16, Verbindung Lok/Wagen 5 und 6 und die Türöffnung bzw. -Schließung 8 mit den jeweils dazugehörigen Tastelementen 9; 10; 11 und 12 und einem Lautsprecher 13 sowie an einer Seitenfläche des Gerätes eine Befestigung für das Mikrophon 14 mit Tastelement 15 und LED16.

### Funktionsbeschreibung

### 1. Funktion der Türsteuerung

"TB-0" Steuerungssignal 24V wird per LED "TB-0" kontrolliert. Mit der Taste 12 "Türen zu" wird ein Signal von 24V an die Lok gegeben. Am Führerstand kommt ein akustisches Signal und Spannung 24V an den Adern 9-12 der UIC-Dose von der Lok aus an. Die LED 8 "TB-0" leuchtet.

### 2. Funktion von Schwanenhalsmikrofon:

Der Lokführer betätigt die Sprechtaste des Schwanenhalsmikrophons des Triebfahrzeuges damit wird die Spannung an den Adern 5-6 und 7-8 angelegt, was per LED 5 "Durchsagen Ein" und LED 6 "Lautsprecher Ein" am Prüfgerät (1) angezeigt wird. Aus dem Lautsprecher (13) des Prüfgerätes (1) kommt die Durchsage des Lokführers.

Der Lokführer bedient die Taste "Zugdurchsage" der GSMR-Anlage am Bediengerät des Triebfahrzeuges. Damit wird die Spannung 24V an die Adern 5-6 und 7-8 der UIC - Dose angelegt, was per LED 5 "Durchsagen Ein" und LED 6 "Lautsprecher Ein" am Prüfgerät (1) angezeigt wird. Aus dem Lautsprecher (13) des Prüfgerätes (1) kommt die Durchsage des Lokführers.

Der Lokführer bedient die Taste "Lok/Lok" am Bediengerät vom GSMR oder ZBF des Triebfahrzeuges. Der Prüfer nimmt das Mikrophon (14) von der Ablage ab, und betätigt die Taste (15/9) die Sprachverbindung zwischen Lokführer und Prüfgerät (1) wird per LED 7 und LED 16 "Lok zu Lok" angezeigt. Die Durchsage des Lokführers am Lautsprecher (13) ist zu hören. Per Mikrophon (14) wird die Durchsage des Prüfers an die Lok weiter geleitet. Am Lautsprecher der Lok ist die Durchsage ebenfalls zu hören.

### 3. Übertragung der Steuersignal "NBÜ" 1000 Hz:

Der Lokführer betätigt den Schalter "NBÜ" an der Rückwand des Führerraumes, damit wird das Steuersignal 1000 Hz 2Volt an die Adern 9-10 der UIC-Dose angelegt. Der Prüfer drückt die Taste (10) "1000Hz Kontrolle" des Prüfgerätes (1) und am Lautsprecher (13) ist der akustische Signal 1000Hz zu hören. Wenn das Signal höher als 1 Volt ist, wird das per LED 4 "1000Hz Anzeige" angezeigt.

### 4. Auslösung der Notbremse von dem Wagen aus:

Der Prüfer betätigt die Taste (11) "Notbremse" und, damit wird die Notbremse ausgelöst. Am Führerstand kommt ein akustisches Signal an. Durch gleichzeitiges Betätigen von den Tasten (11) "Notbremse" und (10) "1000Hz Kontrolle" wird die Notbremse ausgelöst und am Prüfgerät (1) ist kein akustisches Signal 1000 Hz zu hören. Die LED 4 bleibt dann dunkel.

Um die einwandfreie Funktion des Gerätes zu garantieren, wird die Stromversorgung überwacht. Die Stromversorgungsbatterien (19) werden ständig mit einer Spannungs-überwachungsschaltung überwacht. Der Spannungsüberwachungsmodul ist auf der IC3 und der LED 17 "Nichtbetriebsbereitanzeige" aufgebaut. Die Betriebsbereitprüfung wird per drücken der Taste (8) durchgeführt, womit die Batterien (19) unter Last gesetzt werden. Die Batteriespannung ist in Ordnung, wenn die dazugehörigen LED 8 aufleuchten und/oder LED 17 dunkel bleibt.

Das Gerät besteht vorzugsweise aus 5 Modulen, kann allerdings jederzeit um weitere Module erweitert werden:
- Modul 1:: Mikrophon und Mikrophonverstärker IC1
- Modul 2:: Umschaltungsrelais, Endverstärker IC2, Lautsprecher
- Modul 3:: 1000 Hz Überwachungsschaltung, Resonanzschwingkreis und Trenntrafo
- Modul 4:: Schaltspannungsüberwachung
- Modul 5:: Batteriespannungsüberwachung IC3, LED 17

### Liste der verwendeten Bezugszeichen

- 1 -: Prüfgerät
- 2 -: Steckvorrichtung
- 3 -: UIC-Kabel
- 4 -: LED 100 Hz- Anzeige
- 5 -: LED Lok/Wagen
- 6 -: LED Lok/Wagen
- 7 -: LED Lok/Lok
- 8 -: Türöffnung oder - schließung
- 9 -: Tastelement
- 10 -: Tastelement
- 11 -: Tastelement
- 12 -: Tastelement
- 13 -: Lautsprecher
- 14 -: Mikrophon
- 15 -: Tastelement
- 16 -: LED Lok/Lok
- 17 -: LED Batterien lehr anzeige
- 18 -: Endverstärker IC2
- 19 -: Batterien
- 20 -: Modul 1000 Hz Anzeige
- 21 -: Mikrophonverstärker IC1

## Patentansprüche

1. Vorrichtung zur Prüfung von Steckverbindungen und/oder Verbindungskabeln an Triebfahrzeugen, vorzugsweise an schienengebundenen Triebfahrzeugen
***gekennzeichnet dadurch, dass***
ein mobiles, tragbares, elektronisches Prüfgerät - welches über eine Steckvorrichtung für die auf schienengebundenen Triebfahrzeugen vorhandene UIC-Dose und/oder ein UIC-Verbindungskabel verfügt - Tast- und/oder Berührungselemente zur Auslösung eines Signals für eine Funktionsprüfung aller über die UIC-Dose zu versendender Signale, wie beispielsweise
- der Notbremsüberwachung und/oder
- des Zugbahnfunkes und/oder
- der GSMR-Anlage und/oder
- des Lok-zu-Lok-Funkes und/oder
- der Zugbussysteme und/oder
- der Türöffnung oder -schließung und/oder Steuerspannungspolaritätsrichtigkeit
mit dazugehörigen optischen und/oder akustischen Signaleinrichtungen sowie einem Mikrophon (14) aufweist.

2. Vorrichtung nach Anspruch 1, ***gekennzeichnet dadurch, dass*** die optischen Signaleinrichtungen Leuchtdioden oder ähnliche Leuchtmittel sind.

3. Vorrichtung nach Anspruch 1, ***gekennzeichnet dadurch, dass*** die akustische Signaleinrichtung ein Lautsprecher (13) oder eine ähnliche, ein akustisches Signal ausstrahlende Einrichtung ist.

4. Vorrichtung nach Anspruch 1, ***gekennzeichnet dadurch, dass*** das Prüfgerät einen elektronischen Schaltkreis aufweist, der die über die UIC-Dose zu versendenden Signale auf ihre Vollständigkeit und Plausibilität prüft.

5. Vorrichtung nach Anspruch 1, ***gekennzeichnet dadurch, dass*** als Notbremsüberwachung die entsprechende Phase der UIC-Dose über einen Resonanzschwingkreis und einen Trafo mit einem 1000 Hz-Anzeige-Modul (20) und einer Endstufe IC2 (18) verbunden ist.

6. Vorrichtung nach Anspruch 1, ***gekennzeichnet dadurch, dass*** als Zugbahnfunküberwachung (ZBF=GSMR) von Lok/Lok die entsprechende Phase der UIC-Dose über verschiedene Relais und eine Endstufe IC2 (18) mit einem Mikrophonverstärker (21) und LED-Anzeigen verbunden ist.

7. Vorrichtung nach Anspruch 1, ***gekennzeichnet dadurch, dass*** zur Überprüfung des (ZBF=GSMR) von Lok/Wagen die entsprechende Phase der UIC-Dose über verschiedene Relais und die Endstufe IC2 (18) mit LED-Anzeige verbunden ist.

8. Vorrichtung nach Anspruch 1, ***gekennzeichnet dadurch, dass*** die Überprüfung der Türöffnung und/oder Schließungsfunktion und/oder Steuerspannungspolaritätsrichtigkeit die entsprechende Phase der UIC-Dose über eine LED-Anzeige und einen Taster mit einer oder mehreren Batterien (19) verbunden ist.
